# EUROPEAN PATENT APPLICATION

(11) **EP 0 807 534 A1**
(43) Date of publication of application: **19.11.1997**
(21) Application number: 97201336.1
(22) Date of filing: 03.05.1997
(51) Int. Cl.: B41N 1/14, B41N 1/08, G03F 7/20, B41N 6/02

(54) **A flexible supported lithographic printing plate having improved dimensional stability**

(30) Priority: 14.05.1996 EP 96201329
(71) Applicant: AGFA-GEVAERT N.V., 2640 Mortsel (BE)
(72) Inventor: van Hunsel, Johan, 2640 Mortsel (BE); Vermeersch, Joan, 2640 Mortsel (BE); Verlinden, Bartholomeus, 2640 Mortsel (BE)

(57) **Abstract**

The present invention provides an element comprising on a flexible support a lithographic surface defined by ink accepting and ink repellant areas or a latent lithographic surface resulting in a lithographic surface upon development, said imaging element being laminated with its side opposite to the lithographic surface to a dimensionally stable base suitably adapted for mounting on a printing press.
method for making a lithographic printing plate comprising the steps of:
(i) scan-wise exposing an imaging element in accordance with an image pattern, said imaging element comprising on a flexible support a lithographic surface capable of being differentiated in ink accepting and ink repellant areas upon image-wise exposure and optional development;
(ii) laminating a thus obtained scan-wise exposed imaging element with its side opposite to the side carrying said lithographic surface to a dimensionally stable base, said dimensionally stable base being suitably adapted for mounting on a printing press;
(iii) optionally developing said scan-wise exposed imaging element before or after adhering it to said dimensionally stable base.

## Description

### 1. Field of the invention.

The present invention relates to a method for making a lithographic printing plate comprising a flexible support and laminated thereto a dimensionally stable base.

### 2. Background of the invention.

Lithographic printing is the process of printing from specially prepared surfaces, some areas of which are capable of accepting ink (oleophilic areas) whereas other areas will not accept ink (oleophobic areas). The oleophilic areas form the printing areas while the oleophobic areas form the background areas.

Two basic types of lithographic printing plates are known. According to a first type, so called wet printing plates, both water or an aqueous dampening liquid and ink are applied to the plate surface that contains hydrophilic and hydrophobic areas. The hydrophilic areas will be soaked with water or the dampening liquid and are thereby rendered oleophobic while the hydrophobic areas will accept the ink. A second type of lithographic printing plates operate without the use of a dampening liquid and are called driographic printing plates. This type of printing plates comprise highly ink repellant areas and oleophilic areas. Generally the highly ink repellant areas are formed by a silicon layer.

Lithographic printing plates can be prepared using a photosensitive lithographic printing plate precursor, also called imaging element. Such imaging element is exposed in accordance with the image data and is generally developed thereafter so that a differentiation results in ink accepting properties between the exposed and unexposed areas.

Examples of photosensitive lithographic printing plate precursors are for example the silver salt diffusion transfer (hereinafter DTR) materials disclosed in EP-A-410500, EP-A-483415 and EP-A-423399, imaging elements having a photosensitive layer containing diazonium salts or a diazo resin as described in e.g. EP-A-450199, imaging elements having a photosensitive layer containing a photopolymerizable composition as described in e.g. EP-A-502562, EP-A-491457, EP-A-503602, EP-A-471483 or DE-A-4102173.

Alternatively a lithographic printing plate may be prepared from a heat mode recording material as a lithographic printing plate precursor. Upon application of a heat pattern in accordance with image data and optional development the surface of such heat mode recording material may be differentiated in ink accepting and ink repellant areas. The heat pattern may be caused by a direct heating source such as a thermal head but may also be caused by a light source as e.g. a laser. In the latter case the heat mode recording material will include a substance capable of converting the light into heat. Heat mode recording materials that can be used for making a lithographic printing plate precursor are described in e.g. EP-A-573091, DE-A-2512038, FR-A-1.473.751, Research Disclosure 19201 of april 1980 or Research Disclosure 33303 of januari 1992.

As supports for the above mentioned lithographic printing plates there are known metal supports such as e.g. aluminium and flexible supports such as e.g. paper or polyester film supports. Generally the flexible supports are used for short run jobs where they have a cost advantage over metal supports. Furthermore, if a transparent flexible support is used exposure of the lithographic printing plate precursor may proceed through the support which allows the use of cameras without special optics. Still further imaging elements with a flexible support can be used on all kinds of laser imagesetters for film whereas imaging elements having a metal support are not flexible enough to be used on laser imagesetters using internal drum technology. So, when computer-to-plate exposure on an imaging element having a dimensionally stable base is to be made, heavy investment costs are required.

A disadvantage of the use of flexible supported lithographic printing plates is the inherently low dimensional stability which is one of the causes hampering or making totally impossible the use of the printing plate especially when two or more images need to be printed over each other in register such as e.g. in color printing. Furthermore the handling and mounting on a printing press of a lithographic printing plate having a flexible support is cumbersome, surely when the printing plate has considerable dimensions. Attempts have therefore been made to increase the dimensional stability of a flexible supported printing plate by e.g. using a thicker flexible support. Although this brings some improvement, there is still a need for further improvement. Furthermore, the use of a thicker support may cause problems in some processing equipment used for processing the printing plate precursor. The use of a thicker support can also cause problems on the printing press because on most printing presses only printing plates with a thickness of at most 0.30 mm or at most 0.40 mm can be used.

In JP 236692/63 (Kokai) it has been proposed to adhere the flexible support of the printing plate to a metallic plate using a hot-melt adhesive. This method is cumbersome and does not represent a cost advantage over the use of a lithographic printing plate precursor having a metal support. Furthermore the use of a hot-melt adhesive requires the exposure of the printing plate having a flexible support to a high temperature which harms severely the dimensional stability of said printing plate and causes difficulties in bringing two or more plates in register.

EP-A-690349 discloses a flexible offset printing plate for exposure in laser imagesetters and phototypesetters, comprising an aluminum/plastic laminate as the support with a silver halide light-sensitive layer on top of it. The silver halide coating is applied to the aluminum layer, which is a roughened and anodized aluminum sheet of lithographic quality. In this method there is no longer a cost advantage over the use of a lithographic printing plate precursor having a metal support.

US 4,092,925 discloses a method for making lithographic substrates having an aluminum printing member. The light sensitive coating is applied to the aluminum member of the discrete plate, making the reuse of said aluminum printing member cumbersome.

EP 690,349 discloses a method for making lithographic substrates having as support a laminate of aluminum and plastic. The light sensitive coating is applied to the aluminum member of the discrete plate, making the reuse of said aluminum printing member cumbersome.

US 2,048,964 discloses a planographic printing plate comprising a non-metallic core and metallic facings on both sides of the core. Said plate is not suited for reuse of the metallic facing .

EP 644,064 discloses a lithographic printing plate precursor comprising on one side of a flexible support a layer comprising micro-particles of pressure sensitive adhesive covered with a protective stripping layer. As examples of the stripping layer are given paper or a plastic layer. Said layers do not improve the dimensional stability.

DE 4,010,731 discloses a support for a lithographic printing plate comprising a paper base whereon is applied a resin which is hardenable by electron irradiation. Said layers do not improve the dimensional stability.

US 4,032,684 discloses a laminated backing structure for a composite lithographic plate comprising a metal sheet and a laminated backing structure. The light sensitive coating is applied to the metal sheet, making the reuse of said metal sheet cumbersome.

WO 93 10979 discloses a presensitized plate for offset printing comprising a backing film from plastic material, a sheet of metal foil bonded to the backing film and a coating of photosensitive varnishapplied to the metal foil. The reuse of said metal sheet is cumbersome.

US 3,229,628 discloses a printing plate comprising an aluminum foil , a paper layer bonded to a surface of said foil, the aluminum providing a printing surface. The reuse of said metal sheet is cumbersome.

US 3,979,212 discloses a printing plate wich comprise a laminated base of an aluminum sheet laminated to a nonstainless steel sheet . This is a laminate of two metals which is an expensive plateand not reusable.

JP 62 082087 discloses a composition comprising planographic printing sheets, each of which is formed by applying a photosensitive layer to an aluminum foil wherein the printing sheets are adhered to a plastic carrier. The reuse of said aluminum foils is impossible.

### 3. Summary of invention

Accordingly it is an object of the present invention to provide a method for making a lithographic printing plate combining the ease of exposure in an imagesetter of a printing plate precursor with a flexible support with the dimensional stability and ease of handling of a lithographic printing plate with a metal support.

It is a further object of the present invention to provide a method for making a lithographic printing plate combining the cost advantage of a printing plate with a flexible support with the dimensional stability and ease of handling of a lithographic printing plate with a metal support especially when used in printing images over each other in register.

Further objects of the present invention will become clear from the description hereinafter.

According to the present invention there is provided an imaging element comprising on a flexible support a lithographic surface defined by ink accepting and ink repellant areas or a latent lithographic surface resulting in a lithographic image upon development, said imaging element being laminated with its side opposite to the lithographic surface to a dimensionally stable base suitably adapted for mounting on a printing press.

According to the present invention there is further provided a method for making a lithographic printing plate comprising the steps of:
i) scan-wise exposing an imaging element in accordance with an image pattern, said imaging element comprising on a flexible support a lithographic surface capable of being differentiated in ink accepting and ink repellant areas upon image-wise exposure and optional development;
ii) laminating a thus obtained scan-wise exposed imaging element with its side opposite to the side carrying said lithographic surface to a dimensionally stable base , said dimensionally stable base being suitably adapted for mounting on a printing press;
iii) optionally developing said scan-wise exposed imaging material before or after adhering it to said dimensionally stable base.

### 4. Detailed description of the invention

A lithographic printing plate obtained according to the method described above combines the advantages of a printing plate having a flexible support without showing its disadvantages.

An imaging element according to the invention comprises a flexible support. Flexible supports suitable for use in accordance with the present invention may be opaque or transparent, e.g. a paper support or plastic film. When a paper support is used preference is given to one coated at one or both sides with an Alpha-olefin polymer. It is also possible to use a plastic film e.g. poly(ethylene terephthalate) film or poly-Alpha-olefin films. The thickness of such plastic film is preferably comprised between 0.07 and 0.35 mm.

The present invention may be used with any type of lithographic printing plate (precursor), also called an imaging element having a flexible support and capable of laser image recording. Examples are the printing plate (precursors) mentioned in the introduction. The present invention is however especially suitable for use with a lithographic printing plate precursor that is processed according to the DTR-process to obtain a lithographic printing plate. The present invention is also especially suitable for a heat mode recording material, particularly for a heat mode recording material comprising on a support having an oleophilic surface (i) a recording layer containing a light-to-heat converting substance capable of converting radiation into heat and (ii) a cured oleophobic surface layer and wherein said oleophobic surface layer and recording layer may be the same layer.

Said printing plate (precursors) are scan-wise exposed using a laser or a light emitting diode. The light source used is depending on the spectral sensitivity of the imaging element. Argon lasers, helium-neon lasers, semiconductor lasers, e.g. NdYAG or laserdiodes can be used. Said imaging elements are preferably exposed in an apparatus including means for a scanning exposure such as an imagesetter, in particular one of the internal drum type.

A preferred imaging apparatus suitable for image-wise scanning exposure in accordance with the present invention preferably includes a laser output that can be provided directly to the imaging elements surface via lenses or other beam-guiding components, or transmitted to the surface of an imaging element from a remotely sited laser using a fiber-optic cable. A controller and associated positioning hardware maintains the beam output at a precise orientation with respect to the imaging elements surface, scans the output over the surface, and activates the laser at positions adjacent to selected points or areas of the imaging element. The controller responds to incoming image signals corresponding to the original document and/or picture being copied onto the imaging element to produce a precise negative or positive image of that original. The image signals are stored as a bitmap data file on a computer. Such files may be generated by a raster image processor (RIP) or other suitable means. For example, a RIP can accept Input data in page-description language, which defines all the features required to be transferred onto the imaging element, or as a combination of page-description language and one or more image data files. The bitmaps are constructed to define the hue of the color as well as screen frequencies and angles in case of amplitude modulation screening. However the present invention is particularly suitable for use in combination with frequency modulation screening as disclosed in e.g. EP-A-620674.

The imaging apparatus can be configured as a flatbed recorder or preferably as a drum recorder, with the imaging element mounted to the interior or exterial cylindrical surface of the drum.

In a preferred drum configuration, the requisite relative motion between the laser beam and the imaging element is achieved by rotating the drum (and the imaging element mounted thereon) about its axis and moving the beam parallel to the rotation axis, thereby scanning the imaging element circumferentially so the image "grows" in the axial direction. Alternatively the beam can move parallel to the drum axis and, after each pass across the imaging element, increments angularly so that the image on the imaging element "grows" circumferentially. In both cases, after a complete scan by the beam and optional development, an image corresponding to the original will have been applied to the surface of the imaging element. In the flatbed configuration, the beam is drawn across either axis of the imaging element, and is indexed along the other axis after each pass. Of course, the requisite relative motion between the beam and the imaging element may be produced by movement of the imaging element rather than (or in addition to) movement of the beam.

The scan-wise exposed imaging material requires in most cases a development step in order to yield a lithographic printing plate. Depending on the imaging element said development step proceeds by rubbing the exposed imaging element with e.g. a cotton pad and is then completely dry. So, there is a method for making a lithographic printing plate requiring no dampening liquid comprising the steps of:
- image-wise exposing using a laser beam a heat mode recording material comprising on a support having an oleophilic surface or an oleophilic layer thereon (i) a recording layer containing a light-to heat converting substance capable of converting the laser beam radiation into heat and (ii) a cured oleophobic surface layer and wherein said recording layer and surface layer may be the same layer
- rubbing the exposed heat mode recording material thereby removing said oleophobic surface layer in the exposed areas so that the underlying oleophilic surface is exposed and
- avoiding the swelling of said oleophobic surface layer by carrying out said rubbing without the use of a liquid or with the use of a non-solvent for said oleophobic surface layer.

In most cases said development step requires the treatment of said exposed imaging element with an aqueous solution, particularly an aqueous alkaline solution. Said development is preferably done in a developing means.

As mentioned the present invention is especially suitable for use with a lithographic printing plate precursor that is processed according to the DTR-process to obtain a lithographic printing plate.

Such lithographic printing plate precursor comprises on a flexible support in the order given an optional base coat, a silver halide emulsion layer and an image-receiving surface layer.

To obtain a lithographic plate from such a precursor the precursor is scan-wise exposed e.g. by means of a laser or a LED, and is subsequently developed in an alkaline processing liquid in the presence of a developing agent and a silver halide solvent. The plate surface may then be neutralized with a neutralizing agent. After processing the image-receiving layer will bare a silver image that is capable of accepting greasy ink in a printing process using a dampening liquid.

As an alternative said lithographic printing plate precursor comprises in the order given on the hydrophilic surface of a flexible support an image-receiving layer and a silver halide emulsion layer.

To obtain a lithographic plate from such a precursor the precursor is scan-wise exposed e.g. by means of a laser or a LED, and is subsequently developed in in alkaline processing liquid in the presence of a developing agent and a silver halide solvent. The printing plate precursor is then treated to remove the layer(s) on top of the image-receiving layer. After processing the image-receiving layer will bare a silver image that is, optionally after a treatment with a finisher, capable of accepting greasy ink in a printing process using a dampening liquid.

A dimensionally stable base according to the invention comprises a material having an E-modulus of at least 15*10⁹ Pa, preferably in the range between 30*10⁹ and 300*10⁹ Pa.

Suitable bases are for instance metal bases, preferably aluminum or stainless steel bases.

Preferred bases are also bases made of a composite material comprising fibres and a resin matrix. The fibres are preferably selected from carbon fibres, boron fibres, silicon carbide fibres, and mixtures thereof, although other fibres such as glass fibres, aramid fibres, polyamide fibres and natural fibrous materials such as jute may also be used. Preferably the fibres have an average diameter of from 3 µm to 20 µm. The flexural E-modulus of the fibres is preferably greater than 200 GPa.

The majority of the fibres suitably have lengths which extend from one end of the base to the other in the direction of the load, although mixtures of long and short fibres can be used. In fact, the maximum length of the fibres can be somewhat greater than the length of the base where the fibres are applied diagonally.

The fibres may constitute from 30% to 70% by volume of the composite material, although a higher packing fraction is possible with fibres of mixed diameter.

The resin is preferably selected from thermo-setting and thermoplastic polymers, and mixtures thereof, such as epoxy resins, furane resins, silicone resins, polyester resins, phenolic resins, vinylester resins, polyamide (PA) resins, polypropylene (PP) resins, polyethylene resins (PE), polyethylene terephthalate resins (PETP), polybutylene terephthalate resins (PBT), and polyphenyloxide resins (PPO).

The thickness of said dimensionally stable base is preferably comprised between 20 µm and 400 µm, more preferably between 25 µm and 300 µm, most preferably between 50 µm and 250 µm.

A dimensionally stable base in accordance with the invention is suitably adapted for mounting on a printing press. Preferably said dimensionally stable base comprises register "punches" required for mounting a lithographic printing plate on a printing press for printing in register. When required by the printing press used said dimensionally stable base comprises holes for a press pin bar or a bend for mounting the printing plate on a printing press.

The scan-wise exposed imaging element is before or after the optional development of said scan-wise exposed imaging element with its side opposite to the side carrying the lithographic surface laminated to the dimensionally stable base . Said dimensionally stable base may be laminated to said imaging element comprising a flexible support by any adhesive e.g. a glue but the use of an adhesive layer is preferred. Said adhesive layer may be applied to the dimensionally stable base . A preferred layer in such case is a cured silicone layer. More preferably said adhesive layer is applied to the side of the imaging element not having a lithographic surface. Said adhesive layer can be a pressure-adhesive layer but is preferably a thermo-adhesive layer.

Suitable thermo-adhesive layers (TALs) for use in the present invention have a glas transition temperature T_{g} between 10 ^{o}C and 70^{o}C as measured with the 1090 THERMOANALYZER of Du Pont Co.. During a lamination step a minimal thermal load should be imposed to the material in order to save energy and diminish the risk for material change or deformation. For these reasons the T_{g} of the TAL is preferably below 80 ^{o}C. The T_{g} value of the TAL can be determined by the T_{g} value of the polymer(s) used and/or by the addition of polymeric or low-molecular plasticizers or thermosolvents to the thermo-adhesive layer.

In order to induce easy film formation without unwanted sticking of the TAL to the side of the imaging medium carrying the lithographic surface or to other materials a TAL is preferably used with a T_{g} value between 20 ^{o}C and 65 ^{o}C.

For ecological and practical reasons the TAL is preferably coated from an aqueous medium. Therefore the polymers are preferably incorporated as latices.

Preferred latices are latices of styrene, styrene-butadiene, styrene-(meth)acrylate and n.butylacrylate-methylmethacrylate-acrylonitrile. These latices can contain other comonomers which improve the stablitity of the latex, such as acrylic acid, methacrylic acid and acrylamide. Other possible latices include polyvinylacetate, polyethylene-vinylacetate, polyacrylonitrile-butadiene-acrylic acid, polymethylmethacrylate-butylmethacrylate, polymethylmethacrylate-ethylacrylate, polystyrene-butylacrylate, polymethylmethacrylate-butadiene, polyester of terephtalic acid-sulphoisophtalic acid-ethyleneglycol, copolyester of terephtalic acid-sulphoisophtalic acid-hexanediol-ethyleneglycol.

Various additives can be present in the TAL to improve the layer formation or the layer properties, e.g. thickening agents, surfactants, levelling agents, thermal solvents and pigments.

Suitable pressure-adhesive layers (PALs) for use in the present invention comprise one or more pressure sensitive adhesives. Said pressure sensitive adhesives are preferably tacky elastomers e.g. block copolymers of styrene/isoprene, styrene/butadiene rubbers, butyl rubbers, polymers of isobutylene and silicones. Particularly preferred are natural rubbers and acrylate copolymers as disclosed in US-P 3,857,731. Said acrylate polymers preferably consist of 90 to 99.5 % by weight of at least one alkyl acrylate ester and 10 to 0.5 % by weight of a monomer selected from the group consisting of substantially oil-insoluble, water-soluble, ionic monomers and maleic anhydride.

The acrylate ester portion preferably consists of those monomers that are hydrophobic, water emulsifiable, substantially water insoluble and which as homopolymers generally have a glass transition temperature of 20^{o}C or less. Examples of such monomers are iso-octyl acrylate, 4-methyl-2-pentyl acrylate, 2-methylbutyl acrylate and sec-butyl acrylate.

Examples of ionic monomers are e.g. trimethylamine methacrylamide, trimethylamine p-vinylbenzimide, ammonium acrylate, sodium acrylate, N,N-dimethyl-N-1-(2-hydroxypropyl)amine methacrylamide and maleic anhydride. The used pressure sensitive adhesive preferably has a continuous-coat (100% coverage) peel adhesion value, when applied to untreated paper, between 0.1 and 10 N/cm width.

According to the present invention the pressure-adhesive layer comprising a pressure sensitive adhesive may contain a binder. Suitable binders for use in combination with the pressure sensitive adhesives are binders that are inert towards the pressure sensitive adhesives i.e. they do not chemically attack the pressure sensitive adhesives or act as a solvent for them. Examples of such binders are nitrocellulose, urethanes, gelatin, polyvinyl alcohol etc...

The amount of binder should be chosen such that the pressure sensitive adhesives laminate effectively. Preferably the amount of binder is lower than 2.5 parts by weight with respect to the pressure sensitive adhesives and more preferably lower than 0.6.

When the exposed and optionally developed imaging element is laminated with its side opposite to the side carrying the lithographic support to the dimensionally stable base by means of a pressure sensitive layer applied on the side of said flexible support not carrying the lithographic surface a protective layer is used to cover the pressure-sensitive adhesive layer and is removed just before the lamination step. Examples of suitable protective layers are e.g. paper or a thin plastic fim covered with an abhesive layer.

The lamination of the exposed and optionally developed imaging element to the dimensionally stable base is preferably reversible. It means that said imaging element and said dimensionally stable base can still be peeled apart. In the case that the adhesive layer is a cured silicone layer preferably the adhesive force of said adhesive to the surface of said imaging element opposite to the lithographic surface is smaller, preferably at least two times, more preferably at least five times than the adhesive force to said dimensionally stable base. In the other cases, e.g. when the adhesive layer is a thermo-adhesive layer or a pressure-adhesive layer preferably the adhesive force of said adhesive to the surface of said imaging element opposite to the lithographic surface is larger, preferably at least two times, more preferably at least five times than the adhesive force to said dimensionally stable base. In this way the dimensionally stable base can be reused in many makings of a lithographic printing plate according to the invention without the requirement of cleaning said dimensionally stable base. The possibility of the reuse of said dimensionally stable base can lead to an important cost saving.

When the used adhesive is a thermo-sensitive layer either applied on the dimensionally stable base or preferably on the side of the flexible support opposite to the side carrying the lithographic surface said laminating is effected by means of a heating step, preferably at a temperature of less than 100^{o}C, more preferably at a temperature between 35^{o}C and 90^{o}C in order to retain the dimensional stability of the exposed and optional developed imaging element having a flexible support. Said heating may be applied to either or both the imaging element and the dimensionally stable base before, while or after bringing the dimensionally stable base in contact with the side of the support of the imaging material opposite to the side carrying the lithographic surface. Said laminating can be effected manually but preferably said laminating is effected in a laminating means called a laminator. A laminator preferably comprises a pair of two heatable rollers, having an adjustable pressure to each other and moving at a fixed or an adjustable speed. The lamination with a laminator is effected by bringing the two elements which have to be laminated in close contact with each other and said sandwich is then put through between the two rollers of the laminator. The lamination parameters (roller temperature, roller impression and put-through speed) can be etablished dependent on the properties of the dimensionally stable base, of the imaging element and particularly of the TAL so that a good adhesion between the dimensionally stable base and the imaging element comprising a flexible support is obtained.

When the adhesive layer is a pressure-adhesive layer, said lamination requires a pressure step. Said pressure is applied while the dimensionally stable base is in contact with the side of the support of the imaging element opposite to the side carrying the lithographic surface.

The following examples illustrate the present invention without limiting it thereto. All percentages are by weight unless stated otherwise.

### EXAMPLE 1

### Preparation of the silver halide emulsion coating solution.

A silver chlorobromide emulsion composed of 98.2 mol % of chloride and 1.8 mol % of bromide was prepared by the double jet precipitation method. The average silver halide grain size was 0.38 µm (diameter of a sphere with equivalent volume) and contained rhodium ions as internal dopant. The silver iodide-content is established immediately after the physical ripening and before the chemical ripening by means of a co-precipitation of silver nitrate and a water soluble iodide. This gives a more homogeneously distributed silver iodide-content, compared to the traditional means whereby the iodide is implanted during a conversion process. The emulsion contained 0.8 mol% silver iodide/mole silver halide. The chemical ripening is performed directly after the silver iodide precipitation is finished. After the chemical ripening 4-hydroxy-6-methyl-1,3,3a,7-tetraazaindene was added as stabilizer in an amount of 290 mg/mole of silver halide.

Prior to coating the emulsion was red sensitised using a red sensitizing dye in an amount of 4.9*10⁻⁴ mole/mole AgX . Finally 2-mercapto-5-n.heptyl-1,3,4-oxadiazole (33.8 mg/mole of silver halide) and 7-sulpho-nafto-(2,3-d)-oxazolidine-2-thione (540 mg/mole of silver halide) were added to the emulsion.

A base layer coating solution was prepared having the following composition:

| | |
|---|---|
| gelatin | 5.5% |
| carbon black | 0.76% |

### Preparation of the imaging element I (comparative imaging element).

A polyethylene terephthalate film support having a thickness of 175 µm and being provided with an adhesion improving layer was coated with a layer containing gelatin in an amount of 0.4 g/m² and colloidal silica having an average particle diameter of 7 nm in an amount of 0.4 g/m². The adhesion improving layer contained a copolymer of itaconic acid (2 %), vinylidene chloride (88 %) and methylmethacrylate (10 %).

The emulsion coating solution was coated simultaneously with the base layer coating solution by means of the cascade coating technique to the above mentioned subbed polyethylene terephthalate support. The emulsion layer was coated such that the silver halide coverage expressed as AgNO₃ was 1.25 g/m² and the gelatin content was 1.34 g/m². The emulsion layers further contained 0.350 g/m² of 1-phenyl-4,4'-dimethyl-3-pyrazolidone, 0.25g/m² of hydroquinone and 120 mg/m² of formaldehyde as a hardener. The base layer was coated such that the amount of gelatin in the coated layer was 2.7g/m². The base layer further contains titaniumdioxide particles and carbon black as anti-halation means, together with a non-water swellable latex but was free of matting agents. The emulsion layer contains silica particles to improve the water-transport on press.

The thus obtained element was dried and subjected to a temperature of 40^{o}C for 5 days and then the emulsion layer was overcoated with a layer containing PdS as physical development nuclei, hydroquinone at 0.4 g/m² and formaldehyde at 33 mg/m².

### Preparation of imaging element II

An imaging element identical with imaging element I but with a subbed polyethylene terephthalate support of 100 µm thickness was laminated with the side of the imaging element opposite to the side coated with the silver halide emulsion to the thermoadhesive layer of Ozasol PressMatch Dry (a trade name of Hoechst A.G. for a laminate containing a PET-layer of a thickness of 50 µm and a thermo-adhesive layer containing a copolymer of vinylacetate-crotonic acid with a thickness of 5 µm). The PET-layer was then peeled away leaving on the side opposite to the silver halide emulsion containing side of the support a thermo-adhesive layer with a thickness of 5 µm. This procedure was repeated four times yielding at the end an imaging element with a thermo-adhesive layer with a thickness of 25 µm.

The following processing solutions were prepared :

| Developer | A |
|---|---|
| sodium hydroxide (g) | 30 |
| methylhydroquinone (g) | 2 |
| sodium sulphite anh. (g) | 35 |
| 1-methyl,4-butenyl,5-methyl 1,2,4-triazolium-3-thiolate (mg) | 800 |
| 2-Aminoethyl-aminoethanol (ml) | 45 |
| 2-mercapto-5-n.heptyl-oxa-3,4-diazole (mg) | 350 |
| ethylenediamine-tetraacetic acid sodium salt (g) | 1 |
| water to make | 1 l |

| Neutralization solution | |
|---|---|
| citric acid | 10 g |
| sodium citrate | 35 g |
| sodium sulphite anh. | 5 g |
| phenol | 50 mg |
| water to make | 1 l |

The above described imaging elements were image-wise exposed in an imagesetter SelectSet 5000 (trade name of Agfa-Gevaert N.V. for an imagesetter with an internal drum and a HeNe laser) and processed with the above described activator for 20 seconds at 30^{o}C, subsequently neutralized at 25 ^{o}C with the neutralization solution described above and dried. The exposed and developed imaging element I was called lithographic plate I. The exposed and developed imaging element II was then laminated to an aluminum plate of 50 µm by putting the imaging element with its thermo-sensitive layer on said aluminum plate and passing said sandwich trough a laminator Ozasol OPL 70 (trade name of Hoechst A.G.) whereby said sandwich was brought at a temperature of 80^{o}C, yielding lithographic plate II. The aluminum plate comprised register punches and a bend required for mounting the lithographic printing plate on the printing press.

The two printing plates were used for printing in an identical way by putting said plates on a Heidelberg GTO52 press and using a commercial ink and fountain solution.

After printing 10,000 copies the following results were observed:
- the dimensional change as a consequence of the mountening of the lithographic plate on the press cylinder is clearly smaller for lithographic plate II (plate obtained according to the invention) than for lithographic plate I (comparison plate), i.e. 1 mm/m for plate II versus 5 mm/m for plate I;
- the dimensional change while printing is also clearly smaller for lithographic plate II than for lithographic plate I, i.e. 1 mm/m for plate II versus 2 mm/m for plate I.

### EXAMPLE 2

Lithographic plate III was prepare in an identical way to lithographic plate I with the exception that a PET support of 275 µm was used instead of a PET support of 175 µm. Lithographic plate IV was prepared in an identical way as lithographic printing plate II with the exception that a PET support of 175 µm was used instead of a PET support of 100 µm and a stainless steel plate of 75 µm thick was used in stead of an aluminum plate of 50 µm.

Said plates were used for printing 10,000 copies in an identical way as described in example 1. On the last copy the displacement of the image as a function of the distance to the middle of the image was measured. It was found that said displacement for plate IV (plate obtained according to the invention) was 1.23 mm/m and for plate III 3.19 mm/m. So, it is clear that a plate obtained according to the invention shows the advantages of a lithographic plate with a flexible support (f.i. the possibility of a scan-wise exposure in an imagesetter with an internal drum) and a much better dimensional stability.

## Claims

1. An element comprising on a flexible support a lithographic surface defined by ink accepting and ink repellant areas or a latent lithographic surface resulting in a lithographic surface upon development, said element being laminated with its side opposite to the lithographic surface to a dimensionally stable base suitably adapted for mounting on a printing press.

2. An element according to claim 1 wherein said dimensionally stable base is a metallic base.

3. An element according to claim 1 wherein said dimensionally stable base is a base made of a composite material comprising fibres and a resin matrix.

4. An element according to any of the claims 1 to 3 wherein there is an adhesive layer between the side of the support opposite to the side carrying a lithographic surface or a latent lithographic surface and the dimensionally stable base.

5. An element according to claim 4 where said adhesive layer is a pressure-adhesive layer or a thermo-adhesive layer.

6. An element according to claim 4 where said adhesive layer is a cured silicone layer.

7. An element according to claim 4 wherein the adhesive force of said adhesive layer to the surface of said imaging element opposite to the lithographic surface is larger than the adhesive force to said dimensionally stable base.

8. An element according to any of claims 1 to 7 wherein said dimensionally stable base comprises register punches and/or a hole for a press pin bar or a bend for mounting it on a printing press.

9. A method for making a lithographic printing plate comprising the steps of:
(i) scan-wise exposing an imaging element in accordance with an image pattern;
(ii) laminating a thus obtained scan-wise exposed imaging element with its side opposite to the side carrying said lithographic surface to a dimensionally stable base, said dimensionally stable base being suitably adapted for mounting on a printing press;
(iii) optionally developing said scan-wise exposed imaging element before or after adhering it to said dimensionally stable base.

10. A method according to claim 9 wherein said scan-wise exposed imaging element is releasibly laminated to said dimensionally stable base such that scan-wise exposed imaging element and dimensionally stable base can be delaminated from each other in such a way that the base can be recovered for reuse.

11. A method according to claim 9 or 10 wherein said scan-wise exposed imaging element is laminated to said dimensionally stable base by means of an adhesive layer.

12. A method according to claim 11 wherein said adhesive layer is a thermo-adhesive layer and wherein said scan-wise exposed imaging element is laminated to said dimensionally stable base at a temperature of less than 100^{o}C.

13. A method according to any of claims 9 to 12 wherein said imaging element is scan-wise exposed in an apparatus including means for scanning exposure and is subsequently fed, optionally through a developing means, into a laminating means for laminating a thus obtained scan-wise exposed imaging element to a dimensionally stable base.

14. A method for making a copy having at least two colours comprising the steps of:
i) preparing at least two printing plates by a method according to any of claims 9 to 13;
ii) placing said at least two printing plates each on a printing cylinder;
iii) bringing said at least two printing plates in contact with a printing ink and, if necessary with a dampening liquid and
iv) printing.
